# EUROPEAN PATENT APPLICATION

(11) **EP 4 286 442 A1**
(43) Date of publication of application: **06.12.2023**
(21) Application number: 22745985.6
(22) Date of filing: 27.01.2022
(51) Int. Cl.: C08G 18/64, B24B 37/24, C08G 18/10, C08G 18/65, C08K 7/22, C08L 75/12, H01L 21/304

(54) **CURABLE COMPOSITION CONTAINING CYCLIC MULTIFUNCTIONAL MONOMER**

(30) Priority: 29.01.2021 JP 2021012698
(71) Applicant: Tokuyama Corporation, Shunan-shi, Yamaguchi 745-8648 (JP)
(72) Inventor: SHIMIZU, Yasutomo, Shunan-shi, Yamaguchi 745-8648 (JP); FUKUDA, Kazuishi, Shunan-shi, Yamaguchi 745-8648 (JP); KAWASAKI, Takayoshi, Shunan-shi, Yamaguchi 745-8648 (JP)
(74) Representative: Gerauer, Marc Philippé
(86) International application number: PCT/JP2022/003134
(87) International publication number: WO 2022/163766

(57) **Abstract**

The present invention relates to a curable composition containing (A) a cyclic molecule that contains three or more side chains each having at a terminal thereof an active hydrogen-containing group, (B) a urethane prepolymer having an iso(thio)cyanate group on each of both terminals of a molecule, (C) a diol, and (D) an amino group-containing monomer.

According to the present invention, it is possible to provide a curable composition that gives a cured product having a high abrasion resistance and capable of exhibiting superior mechanical properties, in particular, a curable composition that can give a cured product capable of being suitably used in a polishing pad.

## Description

### Technical Field

The present invention relates to a curable composition containing a cyclic molecule that contains three or more side chains each having at a terminal thereof an active hydrogen-containing group, a urethane prepolymer having an iso(thio)cyanate group on each of both terminals of a molecule, a diol, and an amino group-containing monomer, and a novel cured product obtained from the curable composition.

### Background Art

A polishing member is a material used in flattening the other member with an abrasive. Specifically, the polishing member is used, in flattening a surface of a member to be polished, in such a manner that the polishing member is brought into contact with the surface while being slidden with an abrasive in the form of slurry or the like supplied onto the surface. As an example, a polishing pad is included.

In such polishing pads, many polyurethane resins are used. In general, as a polishing member, a material that has a long-lasting good abrasion resistance and a high durability is always desired, in terms of cost reduction, stable production, and increased productivity.

Specifically, a polishing pad is used as a pad material in a chemical mechanical polishing (CMP) method (hereinafter sometimes referred to as a polishing pad). The CMP method is a polishing method that imparts a superior surface flatness, and in particular, is adopted in a process for producing a liquid crystal display (LCD), a glass substrate for hard disk, a silicon wafer, or a semiconductor device.

In recent years, as a compound having a novel structure, polyrotaxane has attracted attention. It is disclosed that when the polyrotaxane is used as a raw material of a polyurethane resin, a polishing pad of the polyurethane resin can exhibit superior polishing characteristics (see PTL 1).

### Citation List

### Patent Literature

PTL 1: WO 2018/092826 A

### Summary of Invention

### Technical Problem

In recent years, a polishing pad that has a further improved performance, in particular, that is superior in the flatness of a member to be polished (edge-dripping prevention) and in the abrasion resistance has been desired. However, the polyurethane resin described in PTL 1 has not been able to sufficiently fulfill the above problems, and since polyrotaxane which is a polymer is used therein, there has been a problem of inferior handleability.

Accordingly, an object of the present invention is to provide a curable composition that is superior in handleability, and that gives a cured product that has high abrasion resistance and can exhibit superior mechanical properties. In particular, an object of the present invention is to provide a curable composition that can give a cured product that can be suitably used in a polishing pad.

### Solution to Problem

The present inventors have made intensive and extensive studies for solving the above problem. As a result of the studies for the purpose of overcoming the problems, the present inventors have found that, by using a curable composition containing a cyclic molecule that contains three or more side chains each having at a terminal thereof an active hydrogen-containing group, a urethane prepolymer, and an amino group-containing monomer, it is possible to obtain a cured product having superior physical properties, and that, by using a diol in combination therewith, it is possible to improve handleability of the curable composition and to control hardness of the resulting cured product, and further have found that, by the combination of the diol and the cyclic molecule that contains three or more side chains each having at a terminal thereof an active hydrogen-containing group, it is possible to obtain a cured product having a superior abrasion resistance, thus completing the present invention.

Specifically, a first aspect of the present invention relates to
a curable composition containing (A) a cyclic molecule that contains three or more side chains each having at a terminal thereof an active hydrogen-containing group (hereinafter also referred to as a "component (A)" or a "cyclic polyfunctional monomer"), (B) a urethane prepolymer having an iso(thio)cyanate group on each of both terminals of a molecule (hereinafter also referred to as a "component (B)" or a "urethane prepolymer"), (C) a diol (hereinafter also referred to as a "component (C)"), and (D) an amino group-containing monomer (hereinafter also referred to as a "component (D)").

A second aspect of the present invention relates to a polishing pad obtained by curing the curable composition according to the first aspect of the present invention.

The present invention relates to the following [1] to [11].
[1] A curable composition containing
   (A) a cyclic molecule that contains three or more side chains each having at a terminal thereof an active hydrogen-containing group,
   (B) a urethane prepolymer having an iso(thio)cyanate group on each of both terminals of a molecule,
   (C) a diol, and
   (D) an amino group-containing monomer.
[2] The curable composition according to the above [1], in which in (A) the cyclic molecule which contains three or more side chains each having at a terminal thereof an active hydrogen-containing group, the side chains each having at a terminal thereof an active hydrogen-containing group have a molecular weight of 300 or more in terms of number average molecular weight.
[3] The curable composition according to the above [1] or [2], in which in (A) the cyclic molecule which contains three or more side chains each having at a terminal thereof an active hydrogen-containing group, the cyclic molecule comprises a cyclodextrin.
[4] The curable composition according to any one of the above [1] to [3], in which in (A) the cyclic molecule that contains three or more side chains each having at a terminal thereof an active hydrogen-containing group, the active hydrogen-containing group comprises a hydroxy group.
[5] The curable composition according to any one of the above [1] to [4], in which (C) the diol has a molecular weight of 100 to 2,000.
[6] The curable composition according to any one of the above [1] to [5], in which (B) the urethane prepolymer which has an iso(thio)cyanate group on each of both terminals of a molecule has an iso(thio)cyanate equivalent of 300 to 1,000.
[7] The curable composition according to any one of the above [1] to [6], in which (C) the diol is contained in an amount of 2 to 50 parts by mass based on 100 parts by mass of a total of the component (A), the component (B), the component (C), and the component (D).
[8] The curable composition according to any one of the above [1] to [7], further containing (E) a fine hollow particle.
[9] The curable composition according to the above [8], in which (E) the fine hollow particle is a fine hollow particle containing a urethane resin or a melamine resin.
[10] A cured product obtained by curing the curable composition according to any one of the above [1] to [9].
[11] A polishing pad containing a cured product according to the above [10]. Advantageous Effects of Invention

The curable composition of the present invention is superior in handleability, and a cured product obtained by curing the curable composition exhibits superior mechanical properties. Furthermore, when the cured product is applied in a polishing pad, a superior abrasion resistance and polishing rate can be exhibited.

### Description of Embodiments

The curable composition of the present invention is a curable composition containing (A) a cyclic molecule that contains three or more side chains each having at a terminal thereof an active hydrogen-containing group, (B) a urethane prepolymer having an iso(thio)cyanate group on each of both terminals of a molecule and, (C) a diol, and (D) an amino group-containing monomer.

The components used in the present invention will be described below.

### <(A) cyclic molecule that contains three or more side chains each having at a terminal thereof an active hydrogen-containing group: component (A)>

The cyclic molecule to be used in the component (A) is not particularly limited as long as it is a cyclic molecule that can contain three or more side chains each having at a terminal thereof an active hydrogen-containing group. For example, as such a cyclic molecule, cyclodextrin, crown ether, benzocrown, dibenzocrown, dicyclohexanocrown, cyclobis (paraquat-1,4-phenylene), dimethoxypillararene, calixresorcinarene, calixarene, and phenanthroline can be mentioned. Among them, cyclodextrin is preferred.

The cyclodextrin has an α form (ring inner diameter 0.45 to 0.6 nm), a β form (ring inner diameter 0.6 to 0.8 nm), and a γ form (ring inner diameter 0.8 to 0.95 nm). A mixture thereof can also be used. In the present invention, α-cyclodextrin and β-cyclodextrin are particularly preferred, and in terms of the cost and physical properties, β-cyclodextrin is most preferred.

The calixresorcinarene is a cyclic molecule obtained by subjecting a resorcinol and an aldehyde of various types to cyclic condensation reaction. The resorcinol is not limited to resorcinol, for example, a resorcinol derivative, such as 2-nitroresorcinol, may be used. As the aldehyde, a known aldehyde can be used with no limitation, and examples thereof include aliphatic aldehydes, such as n-butanal, isobutanal, and heptanal, and aromatic aldehydes, such as benzaldehyde, vanillin, and 4-nitrobenzaldehyde. Two or more thereof may be used in combination. Among them, heptanal, benzaldehyde, and vanillin are suitably used. In the present invention, the calixresorcinarene is preferably a tetramer, but is not limited thereto.

The cyclic molecule used in the component (A) of the present invention contains at least three or more side chains each having at a terminal thereof an active hydrogen-containing group. Examples of the active hydrogen-containing group include a hydroxy group and an amino group, and among them, a hydroxy group is preferred.

The side chains each having at a terminal thereof an active hydrogen-containing group can be introduced, for example, by using a reactive functional group of the cyclic molecule and causing a reaction with the reactive functional group.

Examples of the reactive functional group include a hydroxy group and an amino group, and among them, a hydroxy group is preferred. For example, β-cyclodextrin has 21 OH groups (hydroxy groups) as the reactive functional groups, and side chains are introduced trough a reaction with the OH groups. Thus, up to 21 side chains can be introduced into one β-cyclodextrin molecule. In the present invention, for sufficiently developing the function of the side chains, at least three or more such side chains each having at a terminal thereof an active hydrogen-containing group are required to be introduced. A cyclic molecule having introduced five or more such side chains each having at a terminal thereof an active hydrogen-containing group is preferred, a cyclic molecule having introduced seven or more such side chains each having at a terminal thereof an active hydrogen-containing group is more preferred, and a cyclic molecule having introduced eight or more such side chains each having at a terminal thereof an active hydrogen-containing group is most preferred. The upper limit is not particularly limited, but when the number of side chains introduced is too large, the viscosity of the cyclic polyfunctional monomer may be increased to reduce the handleability. Thus, the number of side chains introduced is particularly preferably in the range of 8 to 18.

The side chains are not particularly limited, but the side chains are each suitably formed by repetition of an organic chain having a number of carbon atoms in the range of 3 to 20. The number average molecular weight of the side chains is, for example, preferably 300 or more. More specifically, the number average molecular weight of the side chain is in the range of 300 to 10,000, preferably 350 to 5,000, and most preferably 400 to 5,000, and the number average molecular weight is most preferably in the range of 400 to 1,500. The number average molecular weight of the side chains can be adjusted by the amount used in introduction of the side chains and can be determined by calculation or can also be determined by measurement of ¹H-NMR.

When the lower limit of the number average molecular weight of the side chains is as described above, superior physical properties are exhibited. Thus, the polishing rate tends to increase in use of a cured product obtained by curing the curable composition of the present invention in a polishing pad. Furthermore, compatibility with the component (B), the component (C), and the component (D) tends to increase. On the other hand, when the upper limit of the number average molecular weight of the side chains is as described above, the hardness of the cured product tends not to decrease and the abrasion resistance tends not to decrease.

The component (A) preferably has a certain range of viscosity. Thus, a superior handleability can be provided, and the appearance and edge dripping property of a polishing pad formed from the curable composition tend to be good. A preferred range of the viscosity at 60°C is 500 mPa·s to 90,000 mPa·s, further preferably 500 mPa s to 10,000 mPa s, and most preferably 1,000 mPa s to 6,000 mPa·s. The viscosity can be determined, for example, with a rotational viscometer.

When the molecular weight of the component (A) is too large, in mixing with another component, for example, the component (B), the handling tends to be difficult and in addition, the compatibility tends to be poor. From such a point of view, the weight average molecular weight Mw of the component (A) is suitably in the range of 1,500 to 200,000 and particularly 2,000 to 50,000, particularly preferably in the range of 2,500 to 10,000, and most preferably in the range of 3,000 to 8,000. For developing stable physical properties, the dispersity is preferably 1.2 or less. The weight average molecular weight Mw and the dispersity are values measured by a GPC measurement method described in Examples given later. The component (A) may form or may not form a complex with another molecule, but as described above, when the molecular weight of the component (A) is too large, the handleability and the compatibility tend to be poor, and thus, (A) the cyclic molecule having active hydrogen group-containing side chains preferably does not form a complex with another molecule.

In the present invention, the side chains as described above may be linear or branched. The side chains can be introduced into the cyclic molecule through a method and compound appropriately selected from the methods and compounds disclosed in WO2015/159875. For example, as a method, ring-opening polymerization; radical polymerization; cationic polymerization; anionic polymerization; living radical polymerization, such as atom transfer radical polymerization, RAFT polymerization, or NMP polymerization can be used, and among them, ring-opening polymerization is suitable. An appropriately selected compound is reacted with a reactive functional group of the cyclic molecule by such a method, whereby side chains of an appropriate size can be introduced.

Examples of the compound reacted with a reactive functional group of the cyclic molecule in the case of ring-opening polymerization include cyclic compounds, such as a cyclic ether, a cyclic siloxane, a cyclic lactone, a cyclic lactam, a cyclic acetal, a cyclic amine, a cyclic carbonate, a cyclic imino ether, and a cyclic thiocarbonate, and side chains derived from the cyclic compound can be introduced into the cyclic molecule.

Among the cyclic compounds, from the viewpoints of high reactivity and, furthermore, easy control of the molecular weight, a cyclic ether, a cyclic lactone, or a cyclic lactam is preferably used.

A side chain obtained by introducing such a cyclic lactone or a cyclic ether through ring-opening polymerization has a hydroxy group at the terminal thereof, and a side chain obtained by introducing a cyclic lactam through ring-opening polymerization has an amino group at the terminal thereof.

Suitably used examples of the cyclic ether, cyclic lactone, cyclic lactam, and cyclic carbonate are shown below.

Cyclic ethers;
ethylene oxide, 1,2-propylene oxide, epichlorohydrin, epibromohydrin, 1,2-butylene oxide, 2,3-butylene oxide, isobutylene oxide, oxetane, 3-methyloxetane, 3,3-dimethyloxetane, tetrahydrofuran, 2-methyltetrahydrofuran, 3-methyltetrahydrofuran, etc.
Cyclic lactones;
four-membered lactones; β-propiolactone, β-methylpropiolactone, L-serine-β-lactone, etc.
five-membered lactones; γ-butyrolactone, γ-hexanolactone, γ-heptanolactone, γ-octanolactone, γ-decanolactone, γ-dodecanolactone, α-hexyl-γ-butyrolactone, α-heptyl-γ-butyrolactone, α-hydroxy-γ-butyrolactone, γ-methyl-γ-decanolactone, α-methylene-γ-butyrolactone, α,α-dimethyl-γ-butyrolactone, D-erythronolactone, α-methyl-γ-butyrolactone, γ-nonanolactone, DL-pantolactone, γ-phenyl-γ-butyrolactone, γ-undecanolactone, γ-valerolactone, 2,2-pentamethylene-1,3-dioxolan-4-one, α-bromo-γ-butyrolactone, γ-crotonolactone, α-methylene-γ-butyrolactone, α-methacryloyloxy-γ-butyrolactone, β-methacryloyloxy-γ-butyrolactone, etc.
six-membered lactones; δ-valerolactone, δ-hexanolactone, δ-octanolactone, δ-nonanolactone, δ-decanolactone, δ-undecanolactone, δ-dodecanolactone, δ-tridecanolactone, δ-tetradecanolactone, DL-mevalonolactone, 4-hydroxy-1-cyclohexanecarboxylic acid δ-lactone, monomethyl-δ-valerolactone, monoethyl-δ-valerolactone, monohexyl-δ-valerolactone, 1,4-dioxan-2-one, 1,5-dioxepan-2-one, etc.
seven-membered lactones; ε-caprolactone, monomethyl-ε-caprolactone, monoethyl-ε-caprolactone, monohexyl-ε-caprolactone, dimethyl-ε-caprolactone, din-propyl-ε-caprolactone, di-n-hexyl-ε-caprolactone, trimethyl-ε-caprolactone, triethyl-ε-caprolactone, tri-n-ε-caprolactone, ε-caprolactone, 5-nonyl-oxepan-2-one, 4,4,6-trimethyl-oxepan-2-one, 4,6,6-trimethyl-oxepan-2-one, 5-hydroxymethyl-oxepan-2-one, etc.
eight-membered lactones; ζ-enantholactone, etc.
other lactones; lactone, lactide, dilactide, tetramethyl glycoside, 1,5-dioxepan-2-one, t-butylcaprolactone, etc.
Cyclic lactams;
four-membered lactams; 4-benzoyloxy-2-azetidinone, etc.
five-membered lactams; γ-butyrolactam, 2-azabicycro(2,2,1)hepta-5-en-3-one, 5-methyl-2-pyrrolidone, etc.
six-membered lactams; ethyl 2-piperidone-3-carboxylate, etc.
seven-membered lactams; ε-caprolactam, DL-α-amino-ε-caprolactam, etc.
eight-membered lactams; ω-heptalactam, etc.
Cyclic carbonates;
ethylene carbonate, propylene carbonate, carbonic acid 1,2-butylene glycerol 1,2-carbonate, 4-(methoxymethyl)-1,3-dioxolan-2-one, (chloromethyl)ethylene carbonate, vinylene carbonate, 4,5-dimethyl-1,3-dioxol-2-one, 4-chloromethyl-5-methyl-1,3-dioxol-2-one, 4-vinyl-1,3-dioxolan-2-one, 4,5-diphenyl-1,3-dioxolan-2-one, 4,4-dimethyl-5-methylene-1,3-dioxolan-2-one, 1,3-dioxan-2-one, 5-methyl-5-propyl-1,3-dioxolan-2-one, 5,5-diethyl-1,3-dioxolan-2-one

One of the cyclic compounds can be used alone or two or more thereof can be used in combination.

In the present invention, a suitably used cyclic compound is a lactone compound or a lactam compound, a particularly suitable lactone compound is a lactone compound, such as ε-caprolactone, α-acetyl-γ-butyrolactone, α-methyl-γ-butyrolactone, γ-valerolactone, or γ-butyrolactone, and a particularly suitable lactam compound is ε-caprolactam, γ-butyrolactam, or DL-α-amino-ε-caprolactam. Among them, furthermore, the most preferred cyclic compound is ε-caprolactone or ε-caprolactam.

When a cyclic compound is allowed to react to introduce a side chain through ring-opening polymerization, it may be difficult to allow a large molecule to directly react due to poor reactivity of a reactive functional group (for example, hydroxy group) of the cyclic molecule, in particular, due to the steric hindrance thereof or the like. In this case, for example, for allowing a lactone compound, such as a caprolactone, as described above to sufficiently react, a method is suitable in which a low molecular weight compound, such as propylene oxide, is first reacted with a reactive functional group of the cyclic molecule to perform hydroxypropylation so as to convert the functional group to a more reactive functional group in advance. A mean in which a side chain is then introduced by ring-opening polymerization using the cyclic compound can be adopted. In this case, the hydroxypropylated moiety can also be considered as a part of the side chain.

In the ring-opening polymerization as described above, a known catalyst can be used with no limitation. For example, an organic titanium compound, such as tetramethyl titanate, tetraethyl titanate, tetrapropyl titanate, or tetrabutyl titanate, an organic tin compound, such as tin 2-ethylhexanoate, dibutyltin dilaurate, tin octylate, dibutyltin oxide, or dibutyltin acetate, a tin(II) halogenide compound, such as tin(II) chloride, tin(II) bromide, or tin(II) iodide, further an acetylacetonate compound of various metals, or an organic carboxylic acid metal salt or the like can be used. When a certain amount of the catalyst remains after the introduction of the side chain, the remaining catalyst acts as a catalyst in curing with the component (B) to cause too rapid curing, resulting in incomplete curing. Thus, the amount of the remaining catalyst is preferably 5,000 ppm or less in terms of the various metals used in the catalyst relative to the component (A). The amount is more preferably 1,000 ppm or less, and most preferably 600 ppm or less. The amount of the remaining catalyst metal can be measured by ICP optical emission as described in Examples given later. On the other hand, when the amount of the catalyst is too small, the rate of the reaction may be too low. Accordingly, the amount of the catalyst when used is preferably 50 ppm or more, and further preferably 100 ppm or more in terms of the various metals used in the catalyst relative to the component (A).

As is understood through the above description, regarding the side chains contained in the cyclic molecule, the side chains having at a terminal thereof an active hydrogen-containing group can be introduced by various methods.

The active hydrogen-containing group is not particularly limited, and examples thereof include a hydroxy group, an amino group, and a thiol group. Among them, in the present invention, a preferred active hydrogen-containing group is a hydroxy group.

The component (A) that can be most suitably used in the present invention is a compound that has α-cyclodextrin or β-cyclodextrin as the cyclic molecule and that has three or more side chains introduced therein, the side chains being polycaprolactone chains obtained by allowing propylene oxide to react with a reactive functional group of the cyclic molecule to form a hydroxypropyl group and then performing ring-opening polymerization with ε-caprolactone.

The method of producing the component (A) is not particularly limited. For example, in the case of the component (A) that can be most suitably used as described above, it is preferred that propylene oxide is first reacted with a hydroxy group of α-cyclodextrin or β-cyclodextrin to convert the hydroxy group into a hydroxypropyl group, and with the hydroxypropyl group, a polycaprolactone chain obtained by ring-opening polymerization of ε-caprolactone is reacted. In this case, the hydroxypropyl group may be reacted with the polycaprolactone chain obtained by ring-opening polymerization, but it is preferred that, in the ring-opening polymerization, ε-caprolactone is subjected to ring-opening polymerization on the hydroxypropyl group acting as a starting point to form the polycaprolactone chain.

The catalyst as described above or an organic solvent may be used, but in terms of convenience and cost, the synthesis is preferably performed with no solvent. By performing synthesis with no solvent, the amount of a metal catalyst can be reduced, and not only the cost of solvent and the time for solvent removal, the cost of removing a catalyst, such as tin, and the like are not necessary, which is significantly advantageous for industrial production.

In the present invention, the cyclic molecule may be combined with another molecule to form a complex. For example, a form of polyrotaxane having a structure in which a chain axial molecule passes through the rings of a plurality of the cyclic molecules and a bulky group is bonded to each of both terminals of the axial molecule so that the cyclic molecules cannot be removed from the axial molecule due to steric hindrance may be used as the component (A).

### <(B) Urethane prepolymer having an iso(thio)cyanate group on each of both terminals of a molecule; component (B)>

In the present invention, the component (B) is a urethane prepolymer having an iso(thio)cyanate group on each of both terminals of a molecule, the urethane prepolymer being obtained by allowing (B2) a diol to react with (B1) a bifunctional iso(thio)cyanate group-containing compound having two iso(thio)cyanate groups in a molecule (hereinafter also referred to as a "component (B1)" or a "bifunctional iso(thio)cyanate group-containing compound").

In the present invention, an iso(thio)cyanate group refers to an isocyanate group or an isothiocyanate group. Thus, the phrase "having two iso(thio)cyanate groups in a molecule" refers to any of a case of having two isocyanate groups, a case of having two isothiocyanate groups, and a case of having one isocyanate group and one isothiocyanate group. The phrase "having an iso(thio)cyanate group on each of both terminals of a molecule" refers to any of a case of having an isocyanate group on each of both terminals of the molecule, a case of having an isothiocyanate group on each of both terminals of the molecule, and a case of having an isocyanate group on one terminal of the molecule and an isothiocyanate group on the other terminal of the molecule.

As the component (B), a known compound can be used with no limitation as long as the compound contains an iso(thio)cyanate group on each of both terminals of the molecule, and one of such compounds may be used alone or two or more thereof may be used in combination.

In the present invention, examples of the component (B1) which is a raw material of the component (B) include polymerizable monomers described in WO2019/198675.

Among them, specifically, 1,5-naphthalene diisocyanate, xylene diisocyanate (o-,m-,p-), 2,4-tolylene diisocyanate, 2,6-tolylene diisocyanate, phenylene diisocyanate (o-,m-,p-), 2,2'-diphenylmethane diisocyanate, 2,4'-diphenylmethane diisocyanate, 4,4'-diphenylmethane diisocyanate, isophorone diisocyanate, 1,3-bis(isocyanatemethyl)cyclohexane, dicyclohexylmethane-4,4'-diisocyanate, or (bicyclo[2.2.1]heptane-2,5(2,6)-diyl)bismethylene diisocyanate is preferably used as the component (B1). Particularly preferably, a component (B1) of an aromatic isocyanate is preferred, and 2,4-tolylene diisocyanate or 2,6-tolylene diisocyanate is most preferred. That is, a urethane prepolymer obtained by allowing the component (B1) to react with the diol (B2) is particularly preferred.

In order for a cured product obtained by curing the curable composition of the present invention to exhibit particularly superior characteristics, diols (B2) at least one of which has a number average molecular weight of 300 to 1,500 are preferably used to produce the component (B).

As the diols (B2) having a number average molecular weight of 300 to 1,500, such diols of different types or different molecular weights can be used in combination. In this case, the diols (B2) are combined such that the number average molecular weight of the diols (B2) as a whole is 300 to 1,500.

For controlling the hardness, strength, and the like of the resulting cured product, in production of the component (B), a diol (B2) having a number average molecular weight of 300 to 1,500 and a diol (B2) having a number average molecular weight of 90 to 300 can also be used in combination. In this case, depending on the types and the amounts of the diols (B2) and the component (B1) used, relative to 100 parts by mass of the diol (B2) having a number average molecular weight of 300 to 1,500, the amount of the component (C) having a number average molecular weight of 90 to 300 is preferably 0 to 50 parts by mass, more preferably 5 to 40 parts by mass, and most preferably 5 to 30 parts by mass.

The component (B) is to have an isocyanate group and/or an isothiocyanate group on each of both terminals of the molecule. Thus, the component (B) is preferably produced so that the total number of moles of isocyanate groups and/or isothiocyanate groups in the component (B1) (n5) and the total number of moles of hydroxy groups in the diol (B2) (n6) satisfy 1 < (n5)/(n6) ≤ 2.3. When two or more types of terminals of the molecule are used by the component (B1), the number of moles of isocyanate groups and/or isothiocyanate groups (n5) is of course the total number of moles of isocyanate groups and/or isothiocyanate groups of the component (B1). The number of moles of hydroxy groups (n6) of two or more diols (B2) is of course the total number of moles of all hydroxy groups.

The iso(thio)cyanate equivalent (the sum of isocyanate equivalent and/or isothiocyanate equivalent) of the component (B) can be determined by quantifying the isocyanate groups and/or isothiocyanate groups of the component (B) according to JIS K 7301. The isocyanate groups and/or isothiocyanate groups can be quantified by the following back titration method. First, the obtained component (B) is dissolved in a dry solvent. Next, di-n-butylamine in an obviously excess quantity relative to the quantity of the isocyanate groups and/or isothiocyanate groups of the component (B) and that has a known concentration is added to the dry solvent to allow all the isocyanate groups and/or isothiocyanate groups of the component (B) to react with the di-n-butylamine. Next, di-n-butylamine that has not been consumed (that has not been involved in the reaction) is titrated with an acid to determine the quantity of the consumed di-n-butylamine. Since the quantity of the di-n-butylamine consumed and the quantity of the isocyanate groups and/or isothiocyanate groups of the component (B) are the same, the iso(thio)cyanate equivalent can be obtained. Since the component (B) is a linear urethane prepolymer having an isocyanate group and/or an isothiocyanate group on each of both terminals, the number average molecular weight of the component (B) is twice the iso(thio)cyanate equivalent. The molecular weight of the component (B) often coincides with a value measured by gel permeation chromatography (GPC).

The component (B) is not particularly limited, but in the present invention, preferably has an iso(thio)cyanate equivalent of 300 to 1,000, more preferably 350 to 800, and most preferably 400 to 600. The reason is considered as follows. That is, it is considered that, when the component (B) having a certain molecular weight reacts with the component (A) to form a cured product, the sizes of the acting moieties of the molecule including the side chains are increased, which leads to a large motion of the molecule itself, resulting in easy recovery from deformation (elastic recovery; low hysterics). It is further considered that, by using the component (B), it is easy to disperse the crosslinking points in the cured product so that the crosslinking points exist in a random and uniform manner, leading to stable performance. In addition, the component (B) within the above range is superior in handleability of the resulting curable composition so that easy control is possible in production and the moldability can be increased. For example, when a cured product obtained by curing the curable composition of the present invention is used as a polishing pad, a polishing pad superior in moldability can be produced.

As the diol (B2), any compound that has two hydroxy groups can be used with no limitation, and, for example, a compound explained as the component (C) described later can be used. Specifically, as the diol (B2), an aliphatic diol, an alicyclic diol, an aromatic diol, a polyester polyol, a polyether polyol, a polycaprolactone polyol, a polycarbonate polyol, a polyacrylic polyol, a castor oil-based polyol, and the like can be used. Among them, an aliphatic diol is preferred, and polyoxy tetramethylene glycol and polypropylene glycol are more preferred.

The method of producing the component (B) used in the present invention is not particularly limited, and the diol (B2) and the component (B1) may be simply reacted by a known method to produce the component (B) having an isocyanate group and/or an isothiocyanate group on each terminal of the molecule.

In addition, for producing the component (B), heat or a urethanization catalyst can be added, as required.

### <Diol (C); component (C)>

As the component (C) used in the present invention, any compound can be used with no limitation as long as the compound has two hydroxy groups in a molecule, and one such compound may be used alone or two or more such compounds may be used in combination.

The component (C) can be used also as a raw material of the component (B). In the present invention, by using the component (C), the handleability can be increased and the hardness of a cured product obtained by curing the curable composition can be controlled, and in combination with the component (A), a superior abrasion resistance can be exhibited.

Examples of the component (C) suitably used in the present invention include, but not limited to, an aliphatic diol, an alicyclic diol, an aromatic diol, a polyester polyol, a polyether polyol, a polycaprolactone polyol, a polycarbonate polyol, a polyacrylic polyol, and a castor oil-based polyol.

Aliphatic diols;
diols, such as ethylene glycol, diethylene glycol, propylene glycol, dipropylene glycol, butylene glycol, 1,5-dihydroxypentane, 1,6-dihydroxyhexane, 1,7-dihydroxyheptane, 1,8-dihydroxyoctane, 1,9-dihydroxynonane, 1,10-dihydroxydecane, 1,11-dihydroxyundecane, 1,12-dihydroxydodecane, neopentyl glycol, glyceryl monooleate, monoelaidin, polyethylene glycol, polypropylene glycol, polyoxytetramethylene glycol, 3-methyl-1,5-dihydroxypentane, dihydroxyneopentyl, 1,6-dihydroxyhexane, 2-ethyl-1,2-dihydroxyhexane, 2-methyl-1,3-dihydroxypropane, and 1,10-dihydroxydecane
Alicyclic diols;
diols, such as hydrogenated bisphenol A, cyclobutanediol, cyclopentanediol, cyclohexanediol, cycloheptanediol, cyclooctanediol, cyclohexanedimethanol, hydroxypropylcyclohexanol, tricyclo[5,2,1,0^{2,6}]decane-dimethanol, bicyclo[4,3,0]-nonanediol, dicyclohexanediol, tricyclo[5,3,1,13,9]dodecanediol, bicyclo[4,3,0]nonane dimethanol, tricyclo[5,3,1,1^{3,9}]dodecane-diethanol, hydroxypropyltricyclo[5,3,1,1^{3,9}]dodecanol, spiro[3,4]octanediol, butylcyclohexanediol, 1,1'-bicyclohexylidenediol, 1,4-cyclohexanedimethanol, 1,3-cyclohexanedimethanol, 1,2-cyclohexanedimethanol, and o-dihydroxyxylylene
Aromatic diols;
diols, such as dihydroxynaphthalene, dihydroxybenzene, bisphenol A, bisphenol F, xylylene glycol, tetrabromobisphenol A, bis(4-hydroxyphenyl)methane, 1,1-bis(4-hydroxyphenyl)ethane, 1,2-bis(4-hydroxyphenyl)ethane, bis(4-hydroxyphenyl)phenylmethane, bis(4-hydroxyphenyl)diphenylmethane, bis(4-hydroxyphenyl)-1-naphthylmethane, 1,1-bis(4-hydroxyphenyl)-1-phenylethane, 2-(4-hydroxyphenyl)-2-(3-hydroxyphenyl)propane, 2,2-bis(4-hydroxyphenyl)butane, 1,1-bis(4-hydroxyphenyl)butane, 2,2-bis(4-hydroxyphenyl)-3-methylbutane, 2,2-bis(4-hydroxyphenyl)pentane, 3,3-bis(4-hydroxyphenyl)pentane, 2,2-bis(4-hydroxyphenyl)hexane, 2,2-bis(4-hydroxyphenyl)octane, 2,2-bis(4-hydroxyphenyl)-4-methylpentane, 2,2-bis(4-hydroxyphenyl)heptane, 4,4-bis(4-hydroxyphenyl)heptane, 2,2-bis(4-hydroxyphenyl)tridecane, 2,2-bis(4-hydroxyphenyl)octane, 2,2-bis(3-methyl-4-hydroxyphenyl)propane, 2,2-bis(3-ethyl-4-hydroxyphenyl)propane, 2,2-bis(3-n-propyl-4-hydroxyphenyl)propane, 2,2-bis(3-isopropyl-4-hydroxyphenyl)propane, 2,2-bis(3-sec-butyl-4-hydroxyphenyl)propane, 2,2-bis(3-tert-butyl-4-hydroxyphenyl)propane, 2,2-bis(3-cyclohexyl-4-hydroxyphenyl)propane, 2,2-bis(3-allyl-4'-hydroxyphenyl)propane, 2,2-bis(3-methoxy-4-hydroxyphenyl)propane, 2,2-bis(3,5-dimethyl-4-hydroxyphenyl)propane, 2,2-bis(2,3,5,6-tetramethyl-4-hydroxyphenyl)propane, bis(4-hydroxyphenyl)cyanomethane, 1-cyano-3,3-bis(4-hydroxyphenyl)butane, 2,2-bis(4-hydroxyphenyl)hexafluoropropane, 1,1-bis(4-hydroxyphenyl)cyclopentane, 1,1-bis(4-hydroxyphenyl)cyclohexane, 1,1-bis(4-hydroxyphenyl)cycloheptane, 1,1-bis(3-methyl-4-hydroxyphenyl)cyclohexane, 1,1-bis(3,5-dimethyl-4-hydroxyphenyl)cyclohexane, 1,1-bis(3,5-dichloro-4-hydroxyphenyl)cyclohexane, 1,1-bis(3-methyl-4-hydroxyphenyl)-4-methylcyclohexane, 1,1-bis(4-hydroxyphenyl)-3,3,5-trimethylcyclohexane, 2,2-bis(4-hydroxyphenyl)norbornane, 2,2-bis(4-hydroxyphenyl)adamantane, 4,4'-dihydroxydiphenyl ether, 4,4'-dihydroxy-3,3'-dimethyldiphenyl ether, ethylene glycol bis(4-hydroxyphenyl) ether, 4,4'-dihydroxydiphenyl sulfide, 3,3'-dimethyl-4,4'-dihydroxydiphenyl sulfide, 3,3'-dicyclohexyl-4,4'-dihydroxydiphenyl sulfide, 3,3'-diphenyl-4,4'-dihydroxydiphenyl sulfide, 4,4'-dihydroxydiphenyl sulfoxide, 3,3'-dimethyl-4,4'-dihydroxydiphenyl sulfoxide, 4,4'-dihydroxydiphenyl sulfone, 4,4'-dihydroxy-3,3'-dimethyldiphenyl sulfone, bis(4-hydroxyphenyl) ketone, bis(4-hydroxy-3-methylphenyl) ketone, 7,7'-dihydroxy-3,3',4,4'-tetrahydro-4,4,4',4'-tetramethyl-2,2'-spirobi(2H-1-benzopyrane), trans-2,3-bis(4-hydroxyphenyl)-2-butene, 9,9-bis(4-hydroxyphenyl)fluorene, 3,3-bis(4-hydroxyphenyl)-2-butanone, 1,6-bis(4-hydroxyphenyl)-1,6-hexanedione, 4,4'-dihydroxybiphenyl, m-dihydroxyxylylene, p-dihydroxyxylylene, 1,4-bis(2-hydroxyethyl)benzene, 1,4-bis(3-hydroxypropyl)benzene, 1,4-bis(4-hydroxybutyl)benzene, 1,4-bis(5-hydroxypentyl)benzene, 1,4-bis(6-hydroxyhexyl)benzene, 2,2-bis[4-(2"-hydroxyethyloxy)phenyl]propane, 4,4'-isopropylidene bis(2-phenoxyethanol), tetrabromobisphenol A bis(2-hydroxyethyl) ether, hydroquinone, and resorcin
Polyester polyols;

They are compounds obtained by condensation reaction of a polyol and a polybasic acid, and an example thereof is such a compound having two hydroxy groups in a molecule. In particular, the number average molecular weight thereof is preferably 300 to 2,000, and most preferably 400 to 1,500. Here, examples of the polyols include ethylene glycol, 1,2-propanediol, 1,3-butanediol, 1,4-butanediol, 3-methyl-1,5-pentanediol, 1,6-hexanediol, 3,3'-dimethylolheptane, 1,4-cyclohexanedimethanol, neopentyl glycol, 3,3-bis(hydroxymethyl)heptane, diethylene glycol, dipropylene glycol, and glycerol. One of the compounds may be used alone or two or more thereof may be used in mixture. Examples of the polybasic acid include succinic acid, adipic acid, azelaic acid, sebacic acid, dodecanedicarboxylic acid, cyclopentanedicarboxylic acid, cyclohexanedicarboxylic acid, orthophthalic acid, isophthalic acid, terephthalic acid, and naphthalenedicarboxylic acid. One of the polybasic acids may be used alone or two or more thereof may be used in mixture.

The polyester polyols are available as a reagent or are industrially available. As examples of commercial products, "Polylite (registered trademark)" series manufactured by DIC Corporation, "Nipporan (registered trademark)" series manufactured by Nippon Polyurethane Industry Co., Ltd., "MAXIMOL (registered trademark)" series manufactured by Kawasaki Kasei Chemicals Ltd., and "KurarayPolyol (registered trademark)" series manufactured by Kuraray Co., Ltd. can be mentioned.

Polyether polyols;
They are compounds obtained by ring-opening polymerization of an alkylene oxide or a reaction of a compound having two or more active hydrogen-containing groups in a molecule and an alkylene oxide, and a modified product thereof. An example thereof is such a compound having two hydroxy groups in a molecule. In particular, the number average molecular weight thereof is preferably 200 to 2,000, and most preferably 200 to 1,500.

As the polyether polyol, a polymer polyol, a urethane-modified polyether polyol, a polyether ester copolymer polyol, and the like can be mentioned. Examples of the compound having two or more hydroxy groups in a molecule include water, glycols having two or more hydroxy group in a molecule, such as ethylene glycol, propylene glycol, butanediol, glycerol, trimethylolpropane, hexanetriol, triethanolamine, diglycerol, pentaerythritol, trimethylolpropane, and hexane triol, and a polyol compound, such as glycerol. One of the compounds may be used alone or two or more thereof may be used in mixture.

Examples of the alkylene oxide include cyclic ether compounds, such as ethylene oxide, propylene oxide, and tetrahydrofuran. One of the compounds may be used alone or two or more thereof may be used in mixture.

The polyether polyols are available as a reagent or are industrially available, and as examples of commercial products, "EXCENOL (registered trademark)" series and "EMULSTAR, (registered trademark)" manufactured by Asahi Glass Co., Ltd., "ADEKA Polyether" series manufactured by ADEKA Corporation, and the like can be mentioned.

Polycaprolactone polyols;
They are compounds obtained by ring-opening polymerization of ε-caprolactone, and an example thereof is such a compound having two hydroxy groups in a molecule. In particular, the number average molecular weight is preferably 300 to 2,000, and most preferably 400 to 1,500.

The polycaprolactone polyols are available as a reagent or are industrially available, and as examples of commercial products, "PLACCEL (registered trademark)" series manufactured by Daicel Corporation and the like can be mentioned.

Polycarbonate polyols;
They are compounds obtained by phosgenation of one or more low molecular weight polyols or compounds obtained by transesterification of one or more low molecular weight polyols with ethylene carbonate, diethyl carbonate, diphenyl carbonate, or the like, and an example thereof is such a compound having two hydroxy groups in a molecule. In particular, the number average molecular weight thereof is preferably 300 to 2,000, and most preferably 400 to 1,500.

Examples of the low molecular weight polyols include low molecular weight polyols, such as ethylene glycol, 1,2-propanediol, 1,3-propanediol, 2-methyl-1,3-propanediol, 1,2-butanediol, 1,3-butanediol, 1,4-butanediol, 1,5-pentanediol, 1,6-hexanediol, 1,8-octanediol, 1,9-nonanediol, 1,10-decanediol, 3-methyl-1,5-pentanediol, 2-ethyl-4-butyl-1,3-propanediol, diethylene glycol, dipropylene glycol, neopentylglycol, cyclohexane-1,4-diol, cyclohexane-1,4-dimethanol, dimer acid diol, a bisphenol A ethylene oxide or propylene oxide adduct, bis(β-hydroxyethyl)benzene, xylylene glycol, glycerol, trimethylolpropane, and pentaerythritol.

The polycarbonate polyols are available as a reagent or are industrially available, and as examples of commercial products, "DURANOL (registered trademark)" series manufactured by Asahi Kasei Chemicals Corporation, "KurarayPolyol (registered trademark)" series manufactured by KURARAY Corporation, "PRACCEL (registered trademark)" series manufactured by Daicel Corporation, "Niporan (registered trademark)" series manufactured by Nippon Polyurethane Industry Co., Ltd., "ETERNACOLL (registered trademark)" series manufactured by Ube Industries, Ltd., and the like can be mentioned.

Polyacrylic polyols;
They are polyol compounds obtained by polymerizing a (meth)acrylate ester or a vinyl monomer, and an example thereof is such a compound having two hydroxy groups in a molecule.
Castor oil-based polyols;

An example of the castor oil-based polyols is a polyol compound obtained by using caster oil which is natural fat and oil as a starting material, and an example thereof is such a compound having a hydroxy group only at each of both terminals of a molecule (two hydroxy groups in a molecule).

The castor oil polyols are available as a reagent or are industrially available, and as examples of commercial products, "URIC (registered trademark)" series manufactured by Ito Oil Chemicals Co., Ltd, and the like can be mentioned.

In the present invention, the component (C) that can be particularly suitably used preferably has a number average molecular weight in the range of 100 to 2,000, further preferably in the range of 150 to 1,000, and most preferably in the range of 200 to 1,000. With a number average molecular weight in the range, a superior handleability is easily imparted.

The number average molecular weights of the component (C) and the aforementioned diol (B2) are each a molecular weight determined by the chemical structure in the case of a compound having no distribution in molecular weight, such as a low molecular weight compound, and is a value based on polystyrene standards measured by gel permeation chromatography (GPC) in the case of a compound having a distribution in the molecular weight, such as a polymer compound.

In the present invention, the component (C) that can be particularly suitably used is preferably selected from an aliphatic diol, and a polyester polyol, a polyether polyol, a polycaprolactone polyol, a polycarbonate polyol, a polyacrylic polyol, and a castor oil-based polyol that are constituted only of an aliphatic moiety, more preferably is an aliphatic diol or a polycarbonate polyol, further preferably an aliphatic diol, and most preferably a polyoxytetramethylene glycol.

### <(D) Amino group-containing monomer; component (D)>

As the component (D) contained in the curable composition of the present invention, any compound can be used with no limitation as long as the compound has two or more primary and/or secondary amino groups in a molecule, and one of such components may be used alone or two or more thereof may be used in combination. In particular, the component (D) preferably has at least a primary amino group in a molecule, and more preferably has two or more primary amino groups in a molecule.

When the component (D) as described above is used, the resulting cured product is a urethane urea resin having a urea bond. This is advantageous for increasing the mechanical strength of the resulting cured product.

In the present invention, the number of amino groups in a molecule of the component (D) is not particularly limited as long as it is two or more. In particular, in view of easy production of the resulting cured product, the effect, and the like, the number is preferably 2 to 6, more preferably 2 to 4, further preferably 2 to 3, and particularly preferably 2.

When the component (D) is roughly classified, it is classified into aliphatic amines, alicyclic amines, aromatic amines, and polyrotaxanes having an amino group that is polymerizable with an isocyanate group. Specific examples of the component (D) include the following compounds.

Aliphatic amines;
bifunctional amines, such as ethylenediamine, hexamethylenediamine, nonamethylenediamine, undecane methylenediamine, dodecamethylenediamine, m-xylenediamine, 1,3-propanediamine, and putrescine
polyfunctional amines, such as polyamines, for example, diethylene triamine.
Alicyclic amines;
bifunctional amines, such as isophoronediamine and cyclohexyldiamine
Aromatic amines;
bifunctional amines, such as 4,4'-methylene bis(o-chloroaniline) (MOCA), 2,6-dichloro-p-phenylenediamine, 4,4'-methylene bis(2,3-dichloroaniline), 4,4'-methylene bis(2-ethyl-6-methylaniline), 3,5-bis(methylthio)-2,4-toluenediamine, 3,5-bis(methylthio) -2,6-toluene diamine, 3,5-diethyltoluene-2,4-diamine, 3,5-diethyltoluene-2,6-diamine, trimethylene glycol di-p-aminobenzoate, polytetramethylene glycol di-p-aminobenzoate, 4,4'-diamino-3,3',5,5'-tetraethyldiphenylmethane, 4,4'-diamino-3,3'-diisopropyl-5,5'-dimethyldiphenylmethane, 4,4'-diamino-3,3',5,5'-tetraisopropyldiphenylmethane, 1,2-bis(2-aminophenylthio)ethane, 4,4'-diamino-3,3'-diethyl-5,5'-dimethyldiphenylmethane, N,N'-di-sec-butyl-4,4'-diaminodiphenylmethane, 3,3'-diethyl-4,4'-diaminodiphenylmethane, m-xylylenediamine, N,N'-di-sec-butyl-p-phenylenediamine, m-phenylenediamine, p-xylylenediamine, p-phenylenediamine, 3,3'-methylene bis(methyl-6-aminobenzoate), 2-methylpropyl 2,4-diamino-4-chlorobenzoate, isopropyl 2,4-diamino-4-chlorobenzoate, isopropyl 2,4-diamino-4-chlorophenylacetate, di-(2-aminophenyl)thioethyl terephthalate, diphenylmethanediamine, tolylenediamine, and piperazine
polyfunctional amines, such as 1,3,5-benzenetriamine and melamine.

In the present invention, the most preferred examples of the component (D) among the above examples include 4,4'-methylene bis(o-chloroaniline) (MOCA), 4,4'-diamino-3,3'-diethyl-5,5'-dimethyldiphenylmethane, 3,5-diethyltoluene-2,4-diamine, 3,5-diethyltoluene-2,6-diamine, 3,5-bis(methylthio)-2,4-toluenediamine, 3,5-bis(methylthio)-2,6-toluenediamine, and trimethylene glycol di-p-aminobenzoate.

In the present invention, the curable composition containing the component (A), the component (B), the component (C), and the component (D) preferably has the following composition.

Specifically, the curable composition preferably contains the component (A) in the range of 2 to 50 parts by mass, the component (B) in the range of 30 to 90 parts by mass, the component (C) in the range of 2 to 50 parts by mass, and the component (D) in the range of 2 to 20 parts by mass, based on 100 parts by mass of the total of the component (A), the component (B), the component (C), and the component (D), more preferably contains the component (A) in the range of 5 to 40 parts by mass, the component (B) in the range of 50 to 80 parts by mass, the component (C) in the range of 5 to 40 parts by mass, and the component (D) in the range of 3 to 10 parts by mass, and most preferably contains the component (A) in the range of 8 to 30 parts by mass, the component (B) in the range of 55 to 80 parts by mass, the component (C) in the range of 8 to 30 parts by mass, and the component (D) in the range of 4 to 10 parts by mass. When the components are contained in the ranges, a cured product obtained by curing the curable composition can exhibit superior abrasion resistance and polishing characteristics.

### <Other components blended in curable composition>

In the curable composition of the present invention, for rapidly promoting the curing, a reaction catalyst for urethane or urea can also be used. As the reaction catalyst for urethane or urea, a known one can be used with no limitation, and as specific examples, those described in WO2015/068798 can be used.

One of the reaction catalysts for urethane or urea can be used alone or two or more thereof can be used in combination, and the amount of the catalyst used may be a so-called catalytic amount, for example, is in the range of 0.001 to 10 parts by mass, in particular, 0.01 to 5 parts by mass, relative to 100 parts by mass of the total of the component (A), the component (B), the component (C), and the component (D).

In the curable composition of the present invention, besides the catalyst, various known compounding agents can be used to the extent that the effect of the present invention is not impaired. For example, other additives, such as an abrasive grain, an antioxidant, an ultraviolet absorber, an infrared absorber, an anti-coloring agent, a fluorescent dye, a dye, a photochromic compound, a pigment, a fragrance, a surfactant, a flame retardant, a plasticizer, a filler, an antistatic agent, a foam stabilizer, a solvent, and a leveling agent, may be added. One of the additives may be used alone or two or more thereof may be used in combination. The additives can be blended in the cured product of the present invention by blending the additives into the curable composition and curing the curable composition.

As a curing method to be used in the present invention, known methods, for example, methods described in WO2015/068798, WO2016/143910, and WO2018/092826 can be adopted. Specifically, a dry method, such as a one-pot method or a prepolymer method, a wet method using a solvent, and the like can be used. Among them, a dry method is suitably adopted.

In the present invention, the cured product obtained by curing the curable composition may be a foam cured product obtained by allowing the cured product to foam. A foam cured product or a non-foam cured product may be selected depending on the desired use purpose or hardness, but when the cured product of the present invention is used as a polishing pad, the cured product is more preferably a foam cured product. Such a foam cured product can be obtained by a known foaming method, for example, by blending a foaming agent or fine particle into the curable composition or by curing the curable composition after blowing gas. Specific examples of the method for allowing the cured product to foam include a foaming agent-foaming method in which a low boiling point hydrocarbon or another volatile foaming agent, water, or the like is added, a method in which a fine hollow particle (micro balloon) is dispersed before curing, a method in which a thermoexpandable fine particle is mixed, followed by heating, to allow the fine particle to foam, or a mechanical floss foaming method in which air or an inert gas, such as nitrogen, is blown in mixing. Among them, in the case where the resulting cured product is to be a foam body when the polishing pad of the present invention is used as a polishing layer, the method using a fine hollow particle is suitable.

The fine hollow particle will be described below.

### <(E) Fine hollow particle; component (E)>

As the fine hollow particle (E) (hereinafter also referred to as the "component (E)") contained in the curable composition of the present invention, a known one can be used with no limitation. As a specific example, a particle having shell formed of a vinylidene chloride resin, a (meth)acrylate resin, an acrylonitrile-vinylidene chloride copolymer, an epoxy resin, a phenol resin, a melamine resin, a urethane resin, or the like can be used. Among them, the component (E) is preferably formed of a urethane resin or a melamine resin, and more specifically, the component (E) is a fine hollow particle composed of shell formed of a urethane resin or a melamine resin and a hollow part surrounded by the shell. In the present invention, the urethane resin is a resin having a urethane bond and/or a urea bond. The melamine resin is a resin produced by polycondensation of melamine and formaldehyde. When such a fine hollow particle is used, a uniform foam body can be produced in an efficient and easy manner. Furthermore, when such a fine hollow particle is used, defect, such as scratch, is rarely generated, and in addition, hysteresis loss also decreases.

The average particle size of the component (E) is not particularly limited, but is preferably in the following range. Specifically, the average particle size is preferably 1 pm to 500 pm, more preferably 5 pm to 200 pm, and most preferably 10 to 100 pm.

The bulk density of the component (E) is also not particularly limited, but is preferably in the following range. Specifically, the bulk density is preferably 0.01 g/cm³ to 0.5 g/cm³, and more preferably 0.02 g/cm³ to 0.3 g/cm³. The bulk density is a density of the component (E) in an expanded state. When the component (E) is a type of a particle that is non-expanded in the stage of mixing with the curable composition of the present invention and that expands by heat in curing, the bulk density in the expanded state is preferably the bulk density as described above.

The amount of the component (E) blended may be appropriately determined according to the use purpose. In particular, when the resulting cured product is used as a polishing pad, the amount of the component (E) blended is preferably as follows. Specifically, relative to 100 parts by mass of the total of the component (A), the component (B), the component (C), and the component (D), the amount of the component (E) blended is preferably 0.1 to 20 parts by mass, 0.2 to 10 parts by mass, and further preferably 0.5 to 8 parts by mass.

The density of the cured product when it is in a foam state is preferably 0.40 to 0.95 g/cm³. In a foaming agent-foaming method with water added, water and an iso(thio)cyanate group are reacted to then generate carbon dioxide and an amino group, and the carbon dioxide acts as foaming gas. On the other hand, the amino group further reacts with an iso(thio)cyanate group to form a urea bond and/or a thiourea bond.

When a cured product obtained from the curable composition of the present invention is used as a polishing pad, the cured product can have any suitable hardness. The hardness can be measured by a Shore method, and, for example, can be measured according to the JIS standard (hardness testing) K6253. In the present invention, the Shore hardness of the cured product in the case of use as a polishing pad is preferably 30A to 70D, further preferably 40A to 60D ("A" indicates a hardness by Shore "A" scale, and "D" indicates a hardness by Shore "D" scale). The hardness can be adjusted to any level by changing the composition and the amounts of components blended according to the need.

When a cured product obtained from the curable composition of the present invention is used as a polishing pad, the cured product preferably has a compression rate in a certain range in order for the polished article to exhibit a flatness. The compression rate can be measured by a method according to JIS L 1096. The compression rate of the cured product is preferably 0.5% to 50%. Within the above range, the polished article can exhibit a superior flatness.

When a cured product obtained from the curable composition of the present invention is used as a polishing pad, the hysteresis loss of the cured product is preferably 60% or less, more preferably 50% or less, and further preferably 40% or less. The hysteresis loss can be measured, for example, by a method according to JIS K 6251. Specifically, a test piece prepared in a form of dumbbell is elongated 100% and is restored, whereby the hysteresis loss (area of elongation and stress in elongation and restoration / area of elongation and stress in elongation × 100) can be measured. With a low hysteresis loss, when using as a polishing pad, the kinetic energy of the abrasive grain can supposedly be evenly used in polishing of the article to be polished, and thus, a superior flatness and a high polishing rate can be exhibited. Furthermore, with a low hysteresis loss, it is considered that a superior polishing rate can be exhibited even in a soft pad. The "area of elongation and stress in elongation and restoration" in the measurement of the hysteresis loss is represented by "area of stress-strain curve in elongation - area of stress-strain curve in contraction", and the "area of elongation and stress in elongation" means the "area of stress-strain curve in elongation".

When a cured product obtained from the curable composition of the present invention is used as a polishing pad, regarding the abrasion resistance of the cured product, the abrasion loss in a Taber abrasion test is preferably 60 mg or less, and further preferably 50 mg or less. With a small Taber abrasion loss, a superior abrasion resistance can be exhibited when the cured product is used as a polishing pad. As a specific method of the Taber abrasion test, a method described in Examples given later can be used.

When a polishing pad is composed of a plurality of layers, the cured product can be used as a member of the polishing pad in at least any of layers. For example, when a polishing pad is composed of two layers, the polishing pad has a two-layer structure composed of a polishing layer (also referred to as a first layer) having a polishing surface that is to be in contact with an article to be polished during polishing and a foundation layer (also referred to as a second layer) that is adjacent to the surface of the first layer that is opposite to the polishing surface. In this case, by allowing the second layer and the first layer to have different hardnesses and elastic moduluses, the characteristics of the polishing pad can be controlled. In this case, the foundation layer preferably has a hardness lower than that of the polishing layer. In the present invention, the cured product can be used not only in the polishing layer but also in the foundation layer.

When the cured product is used as a polishing pad, by blending an abrasive grain into the curable composition and then curing the curable composition, an abrasive grain-fixed cured product can be produced. Examples of the abrasive grain include a particle formed of a material selected from cerium oxide, silicon oxide, alumina, silicon carbide, zirconia, iron oxide, manganese dioxide, titanium oxide, and diamond and two or more particles formed of the materials. The method of blending such an abrasive grain is not particularly limited, and, for example, by dispersing the abrasive grain in the curable composition and then curing the curable composition, the abrasive grain can be blended in the cured product.

In the present invention, the form of the polishing pad is not particularly limited, and a groove structure can be formed on a surface thereof. In particular, the groove structure preferably has such a form that holds and updates a slurry therein in polishing a member to be polished. Specific examples thereof include X (stripe) grooves, XY lattice grooves, concentric circular grooves, a through hole, a non-through hole, a polygonal column, a circular column, a spiral groove, eccentric circular grooves, radial grooves, and a combination of such grooves.

A method of producing the groove structure is not particularly limited. Examples of the method include a mechanical cutting method using a jig, such as a cutting tool of a predetermined size, a production method in which a resin is poured into a mold having a predetermined surface shape and the resin is cured, a method in which a resin is pressed with a pressing plate having a predetermined surface shape, a production method using a photolithography, a production method using a printing technique, and a production method with laser light using carbonic acid gas laser.

In the present invention, for example, by applying the curable composition on a nonwoven fabric or impregnating a nonwoven fabric with the curable composition, followed by curing, a polishing pad in the form of nonwoven fabric can also be produced.

### Examples

Next, the present invention will be described in detail below with reference to Examples and Comparative Examples. The present invention is not to be limited to the Examples. In the following Examples and Comparative Examples, the evaluation methods and the like are as follows.

### [Measurement method]

### (Molecular weight measurement; gel permeation chromatography (GPC measurement))

For GPC measurement, a liquid chromatography apparatus (manufactured by Nihon Waters K. K.) was used as an apparatus. As a column, according to the molecular weight of the sample to be analyzed, Shodex GPC KF-802 (exclusion limit molecular weight: 5,000) or KF802.5 (exclusion limit molecular weight: 20,000) manufactured by Showa Denko K.K. was appropriately used. Dimethylformamide (DMF) was used as an eluent and measurement was performed under conditions of a flow rate of 1 ml/min and a temperature of 40°C. The weight average molecular weight was determined by comparison and conversion based on polyethylene oxides used as standard samples. As a detector, a differential refractometer was used.

### (Viscosity measurement)

The viscosity was measured using a Brookfield-type rotational viscometer (BROOKFIELD RST-CPS Rheometer manufactured by EKO INSTRUMENTS CO., LTD.) under the conditions of 60°C and a shear stress of 100 (Pa).

### (Remaining tin measurement; ICP optical emission spectrometry)

The ICP optical emission was measured, after dissolving a sample in a mixed liquid of methyl isobutyl ketone and isopropyl alcohol as a solvent at 1,000 ppm, using an ICP optical emission spectrometer (iCAP 6,500 DUO manufactured by Thermo Fisher Scientific K.K.), and the amount of the metal contained in the extract was calculated.

### [Evaluation method]

(1) Density: the density (g/cm³) was measured with (DSG-1) manufactured by Toyo Seiki Seisaku-sho, Ltd.
(2) D hardness: according to JIS standard (hardness testing) K6253, the Shore D hardness was measured with a durometer manufactured by KOBUNSHI KEIKI CO., LTD. Sample pieces were stacked into a thickness of 6 mm for measurement. A sample having a relatively low hardness was measured in the Shore A hardness, and a sample having a relatively high hardness was measured in the Shore D hardness.
(3) Abrasion resistance: Taber abrasion test was performed with the model 5130 apparatus manufactured by Taber Industries. The Taber abrasion test was performed at a load of 1 kg, a rotation speed of 60 rpm, and a number of rotations of 1,000 with an H-18 abrasion wheel to measure the abrasion.
(4) Hysteresis loss: a resin stamped out into a shape of Type 8 dumbbell of a thickness of 2 mm was elongated 20 mm at 10 mm/min with an AG-SX autograph manufactured by SHIMADZU CORPORATION, and then, was restored until the stress became zero, and the hysteresis loss in the process was measured.
(5) Appearance evaluation
   The surface appearance (on one surface) of ten sheets (500 mmcp) of a polishing pad produced was evaluated, and the total number of appearance defects, such as voids, of more than 200 pm was
   1: less than 2
   2: 2 or more and less than 5
   3: 5 or more and less than 10
   4: 10 or more
(6) Polishing rate: polishing was performed under the following conditions, and then, the polishing rate was measured. The average values often sheets of 2-inch sapphire wafer was taken as the polishing rate.
   CMP Polishing pad: a 1-mm thickness pad having concentric grooves formed on the surface and having a size of 500 mmϕ
   Slurry: FUJIMI COMPOL 80 stock solution
   Pressure: 4 psi
   Rotation speed: 45 rpm
   Time: 1 hour
(7) Scratch resistance: in polishing under the conditions as described in the above (6), the presence or absence of a scratch in the ten sheets of wafer was checked. The evaluation was performed according to the following criteria.
   1: In measurement with a laser microscope, no defect was seen in all the ten sheets of wafer
   2: In measurement with a laser microscope, a scratch was seen on one of ten sheets of wafer
   3: In measurement with a laser microscope, a scratch was seen on two or more of ten sheets of wafer
(8) Edge dripping property: in polishing under the same conditions as in the scratch resistance of (7), edge dripping on the 2-inch sapphire wafer was checked.
The evaluation was performed according to the following criteria.
1: In measurement of an edge part of the wafer with a laser microscope, edge dripping within 30 pm was seen
2: In measurement of an edge part of the wafer with a laser microscope, edge dripping within 60 pm was seen
3: In measurement of an edge part of the wafer with a laser microscope, edge dripping more than 90 pm was seen
4: In measurement of an edge part of the wafer with a laser microscope, edge dripping more than 120pm was seen
5: In measurement of an edge part of the wafer with a laser microscope, edge dripping more than 150 pm was seen

### [Each component]

### <Component (A)>

### · A-1: cyclic polyfunctional monomer having β-cyclodextrin as a cyclic molecule and having nine side chains with a terminal hydroxy group

### (Physical properties of A-1)

Weight average molecular weight Mw (GPC): 4,800
Dispersity (GPC): 1.05
Degree of modification of side chains: 0.43 (43% as indicated in %)
Active hydrogen-containing group at a terminal of each side chain: hydroxy group Number of side chains contained in the cyclic molecule: 9
Molecular weight of side chains: number average molecular weight of about 560 Viscosity: 3,800 mPa s
Amount of remaining tin: 300 ppm

### (Method of producing A-1)

Under flow of dry nitrogen, 10 g of hydroxypropylated β-cyclodextrin (manufactured by CycloChem Co., Ltd.) and 32.0 g of ε-caprolactone were heated to 130°C with stirring to form a uniform solution, and then, dehydration was performed under a reduced pressure of 20 kPa over 5 hours. Then, it was confirmed that the water content in the reaction system was 80 ppm. Then, 0.04 g of tin(II) 2-ethylhexanoate was added and the mixture was reacted for 16 hours to obtain A-1 as a target product. The physical properties of A-1 were as described above. The number of side chains and the molecular weight were calculated with a ¹H-NMR measurement apparatus (JNM-LA500 manufactured by JEOL Ltd.).

### · A-2: polyrotaxane that has cyclic polyfunctional monomer having α-cyclodextrin as a cyclic molecule and having nine side chains with a terminal hydroxy group

### (Physical properties of A-2)

Weight average molecular weight Mw (GPC): 120,000
Dispersity (GPC): 1.23
Degree of modification of side chains: 0.5 (50% as indicated in %)
Active hydrogen-containing group at a terminal of each side chain: hydroxy group Number of side chains contained in the cyclic molecule: 9
Molecular weight of side chains: number average molecular weight of about 350 Viscosity: 71,000 mPa·s
Amount of remaining tin: 800 ppm

### (Method of producing A-2)

A linear polyethylene glycol (PEG) having a molecular weight of 10,000 was used as an axial molecule, and 10 g of PEG, 100 mg of TEMPO (2,2,6,6-tetramethyl-1-piperidinyloxy radical), and 1 g of sodium bromide were dissolved in 100 mL of water. Into this solution, 5 mL of an aqueous sodium hypochlorite solution (effective chlorine concentration 5%) was added, followed by stirring at room temperature for 10 minutes. Then, 5 mL of ethanol was added to terminate the reaction. Then, after extraction with 50 mL of methylene chloride, methylene chloride was distilled off. The residue was dissolved in 250 mL of ethanol and was subjected to precipitation again at a temperature of -4°C over 12 hours, and PEG-COOH was collected and dried.

3 g of the prepared PEG-COOH and 12 g of α-cyclodextrin (α-CD) were each dissolved in 50 mL of water at 70°C, and the resulting solutions were combined and thoroughly mixed with shaking. Next, the mixed solution was subfected to precipitation again at a temperature of 4°C over 12 hours and the precipitated inclusion complex was collected by lyophilization. Then, 0.13 g of adamantane amine was dissolved in 50 ml of dimethylformamide (DMF) at room temperature, and then the inclusion complex was added thereto and the mixture was quickly thoroughly mixed with shaking. Subsequently, a solution of 0.38 g of a benzotriazol-1-yl-oxy-tris(dimethylamino)phosphonium hexafluorophosphate reagent in 5 mL of DMF was further added thereto and the mixture was thoroughly mixed with shaking. Furthermore, a solution of 0.14 ml of diisopropylethylamine in 5 mL of DMF was added thereto and the mixture was thoroughly mixed with shaking to obtain a slurry reagent.

The slurry reagent obtained above was allowed to stand at 4°C for 12 hours. Then, 50 ml of a DMF/methanol mixed solvent (volume ratio 1/1) was added thereto, followed by mixing and centrifugation, and the supernatant was discarded. Furthermore, after washing with the DMF/methanol mixed solution, the resultant was washed with methanol, followed by centrifugation to obtain a precipitate. After the resulting precipitate was dried by vacuum drying, the resultant was dissolved in 50 mL of dimethyl sulfoxide (DMSO), and the resulting transparent solution was added dropwise into 700 mL of water to precipitate polyrotaxane. The precipitated polyrotaxane was collected by centrifugation and was dried in vacuum. The resultant was further dissolved in DMSO, was precipitated in water, and the precipitate was collected and dried to obtain purified polyrotaxane. Number of inclusions of α-CD molecules at this time was 0.25. Here, the number of inclusions was measured and calculated with a ¹H-NMR measurement apparatus (JNM-LA500 manufactured by JEOL Ltd.).

500 mg of the purified polyrotaxane was dissolved in 50 mL of an aqueous 1 mol/L NaOH solution, 3.83 g (66 mmol) of propylene oxide was added thereto, followed by stirring in an argon atmosphere at room temperature for 12 hours. Next, an aqueous 1 mol/L HCl solution was used to neutralize the polyrotaxane solution into pH7 to 8, and the resultant was subjected to dialysis with a dialysis tube, followed by lyophilization to obtain hydroxypropylated polyrotaxane. The resulting hydroxypropylated polyrotaxane was identified by ¹H-NMR and GPC to confirm that it was a hydroxypropylated polyrotaxane having a desired structure. The degree of modification of a hydroxy group of the cyclic molecule with a hydroxypropyl group was 0.5, and the weight average molecular weight Mw as determined by GPC measurement was 50,000.

5 g of the resulting hydroxypropylated polyrotaxane was dissolved in 15 g of ε-caprolactone at 80°C to prepare a mixed liquid. The mixed liquid was stirred with dry nitrogen blowing at 110°C for 1 hour, and then, 0.16 g of a 50 wt% solution of tin(II) 2-ethylhexane in xylene was added, and the mixture was stirred at 130°C for 6 hours. Then, xylene was added to obtain an A-2 xylene solution of about 35% by mass in non-volatile concentration.

The prepared A-2 xylene solution was added dropwise into hexane, followed by collection and dry to obtain A-2.

### <Component (B)>

### · Pre-1: a urethane prepolymer having an iso(thio)cyanate group on each of both terminals of a molecule, having an iso(thio)cyanate equivalent of 540

### (Method of producing Pre-1)

In a flask equipped with a nitrogen introducing tube, a thermometer, and a stirrer, 400 g of 2,4-tolylene diisocyanate and 1,000 g of polyoxytetramethylene glycol (number average molecular weight; 1,000) were reacted in a nitrogen atmosphere at 80°C for 6 hours to obtain a terminal-isocyanate urethane prepolymer (Pre-1) having an iso(thio)cyanate equivalent of 540.

### · Pre-2: urethane prepolymer having an iso(thio)cyanate group on each of both terminals of a molecule, having an iso(thio)cyanate equivalent of 460

### (Method of producing Pre-2)

In a flask equipped with a nitrogen introducing tube, a thermometer, and a stirrer, 1,000 g of 2,4-tolylene diisocyanate and 1,100 g of polypropylene glycol (number average molecular weight; 500) were reacted in a nitrogen atmosphere at 80°C for 4 hours, and then, 120 g of diethylene glycol was added thereto, followed by reaction at 80°C for 5 hours to obtain a terminal isocyanate urethane prepolymer (Pre-2) having an iso(thio)cyanate equivalent of 460.

### <Component (C)>

· PCD5: DURANOL (polycarbonate diol obtained by using 1,5-pentanediol and hexanediol as raw materials, number average molecular weight 500) manufactured by Asahi Kasei Chemicals Corporation.
· PCD10: DURANOL (polycarbonate diol obtained by using 1,5-pentanediol and hexanediol as raw materials, number average molecular weight 1,000) manufactured by Asahi Kasei Chemicals Corporation.
· PCD20: DURANOL (polycarbonate diol obtained by using 1,5-pentanediol and hexanediol as raw materials, number average molecular weight 2,000) manufactured by Asahi Kasei Chemicals Corporation.
· PTG2.5: polyoxytetramethylene glycol having a number average molecular weight of 250
· PTG6.5: polyoxytetramethylene glycol having a number average molecular weight of 650
· PTG10: polyoxytetramethylene glycol having a number average molecular weight of 1,000
· PTG20: polyoxytetramethylene glycol having a number average molecular weight of 2,000
· PEG10: polyethylene glycol having a number average molecular weight of 1,000
· PPG10: polypropylene glycol having a number average molecular weight of 1,000
· P530: (polyester diol obtained by using 3-methyl-1,5-pentanediol and isophthalic acid as raw materials, number average molecular weight 500) manufactured by KURARAY Corporation
· DEG: diethylene glycol
· MPD: 3-methyl-1,5-pentanediol
· C1: 1,6-dihydroxyhexane
· C2: 1,10-dihydroxydecane
· C3: cyclohexanedimethanol
· C4: tricyclo[5,2,1,0²,⁶]decane -dimethanol
· C5: tetrabromobisphenol A bis(2-hydroxyethyl) ether

### <(D)Amino group-containing monomer>

### · MOCA: 4,4'-methylene bis(o-chloroaniline)

### <(E) Fine hollow particle>

· E1: hollow microcapsule 920-40 (manufactured by Japan Fillite co., ltd.), particle diameter: 40 pm, bulk density: 0.02 g/cm3
· E2: hollow melamine resin microballoon, particle diameter: 30 pm, bulk density: 0.13 g/cm3

### (Method of producing E2)

The component (a) was prepared only with 100 parts by mass of toluene. Next, 10 parts by mass of polyethylene-maleic anhydride was mixed with 200 parts by mass of water, and the mixed liquid was adjusted to pH4 with an aqueous 10% sodium hydroxide solution to prepare the component (b). Next, the prepared component (a) and component (b) were mixed, followed by stirring with a highspeed shear disperser under conditions of 2,000 rpm, 10 minutes, and 25°C to prepare an O/W emulsion. To the prepared O/W emulsion, 9 parts by mass of a melamine formaldehyde prepolymer compound (Nikaresin S-260) was added, and the mixture was stirred at 65°C for 24 hours, then was cooled to 30°C. Then, an aqueous ammonia solution was added until the pH reached at 7.5 to obtain a microballoon dispersion having a resin film of a melamine resin. The resulting microballoon dispersion was subjected to filtration to collect the microballoon, and was dried in vacuum at a temperature of 60°C for 24 hours to obtain a fine hollow particle. Then, aggregate was removed with a sieve of an aperture of 75 pm to obtain E2.

### <Example of application to polishing pad>

### <Example 1>

12 parts by mass of A-1 as the component (A), 11 parts by mass of PCD5 as the component (C), and 6 parts by mass of MOCA as the component (D) were mixed at 120°C to form a uniform solution, followed by sufficient degassing to prepare a liquid A. Separately, 0.8 parts by mass of E1 as the component (E) was added to 71 parts by mass of Pre-1 as the component (B) produced as described above and heated to 70°C, and the mixture was stirred with a revolution-rotation stirrer to prepare a liquid B as a uniform solution. The liquid A was added to the liquid B, and the mixture was uniformly mixed to prepare a curable composition. The curable composition was injected into a mold, followed by defoaming under a reduced pressure of 5 kPa for 2 minutes, and then, was cured at 100°C for 15 hours. After completion of curing, the resultant was removed from the mold to obtain a cured product. The amounts of the components blended are shown in Table 1.

Next, the resulting cured product was sliced to produce cured products having a thickness of 2 mm and a thickness of 1 mm. The cured product having a thickness of 2 mm obtained by slicing was used to measure the following various physical properties. The resulting cured product had a density of 0.85 g/cm³, a shore D hardness of 23D, an abrasion resistance of 30 mg, a hysteresis loss of 44%, and an appearance score of foam cured product of 1.

A spiral groove was formed on a surface of the cured product having a thickness of 1 mm obtained by slicing, and a double-sided tape was attached to the back face to produce a polishing pad of a 500 mmϕ size including the cured product having a thickness of 1 mm.

The polishing pad including the cured product obtained above showed a polishing rate of 3.0 pm/hr and a scratch score of 1. The results are also shown in Table 1.

### <Examples 2 to 42, Comparative Examples 1 to 4>

Cured products and polishing pads were produced in the same manner as in Example 1 except for using the compositions shown in Table 1 and were subjected to the evaluations. The results are shown in Table 1.

**Table 1**

| | Curable composition | | | | | Evaluation result | | | | | | | |
|---|---|---|---|---|---|---|---|---|---|---|---|---|---|
| | Component (A) (parts by mass) | Component (B) (parts by mass) | Component (C) (parts by mass) | Component (D) (parts by mass) | Component (E) (parts by mass) | Density (g/cm³) | D hardness | Abrasion resistance (mg) | Hysteresis loss (%) | Appearance score | Polishing rate (µm/hr) | Scratch resistance | Edge dripping property |
| Example 1 | A-1 ((12) | Pre-1 (71) | PCD5 (11) | MOCA (6) | E1 (0.8) | 0.85 | 23 | 30 | 44 | 1 | 3 | 1 | 1 |
| Example 2 | A-1 ((12) | Pre-2 (67) | PCD5 (15) | MOCA (6) | E1 (0.8) | 0.85 | 23 | 21 | 39 | 1 | 3.2 | 1 | 1 |
| Example 3 | A-1 (19) | Pre-2 (69) | PCD5 (3) | MOCA (9) | E1 (0.8) | 0.85 | 40 | 44 | 67 | 2 | 2.4 | 1 | 1 |
| Example 4 | A-1 (17) | Pre-2 (69) | PCD5 (6) | MOCA (8) | E1 (0.8) | 0.85 | 36 | 35 | 60 | 1 | 2.8 | 1 | 1 |
| Example 5 | A-1 (12) | Pre-2 (60) | PCD10 (22) | MOCA (6) | E1 (0.8) | 0.85 | 22 | 22 | 36 | 1 | 3.1 | 1 | 2 |
| Example 6 | A-2 (23) | Pre-2 (59) | PCD5 (13) | MOCA (5) | E1 (0.8) | 0.85 | 22 | 20 | 28 | 3 | 3.2 | 1 | 4 |
| Example 7 | A-1 ((12) | Pre-2 (67) | PCD5 (15) | MOCA (6) | E2 (10.0) | 1 | 23 | 19 | 33 | 1 | 3.8 | 1 | 1 |
| Example 8 | A-1 (15) | Pre-2 (64) | PCD10 (14) | MOCA (7) | E1 (0.8) | 0.85 | 32 | 36 | 50 | 1 | 3.1 | 1 | 1 |
| Example 9 | A-1 (18) | Pre-2 (67) | PCD10 (6) | MOCA (9) | E1 (0.8) | 0.85 | 33 | 40 | 61 | 1 | 2.6 | 1 | 1 |
| Example 10 | A-1 ((12) | Pre-2 (53) | PCD20 (29) | MOCA (6) | E1 (0.8) | 0.85 | 23 | 37 | 44 | 1 | 2.4 | 2 | 1 |
| Example 11 | A-1 (17) | Pre-2 (61) | PCD20 (14) | MOCA (8) | E1 (0.8) | 0.85 | 26 | 40 | 55 | 1 | 2.4 | 1 | 1 |
| Example 12 | A-1 (19) | Pre-2 (66) | PCD20 (6) | MOCA (9) | E1 (0.8) | 0.85 | 32 | 43 | 62 | 1 | 2.3 | 1 | 1 |
| Example 13 | A-1 (11) | Pre-2 (74) | PTG2.5 (10) | MOCA (5) | E1 (0.8) | 0.85 | 23 | 20 | 39 | 1 | 3.2 | 1 | 1 |
| Example 14 | A-1 ((14) | Pre-2 (72) | PTG2.5 (7) | MOCA (7) | E1 (0.8) | 0.85 | 28 | 32 | 48 | 1 | 2.9 | 1 | 1 |
| Example 15 | A-1 (17) | Pre-2 (71) | PTG2.5 (4) | MOCA (8) | E1 (0.8) | 0.85 | 33 | 41 | 54 | 1 | 2.7 | 2 | 1 |
| Example 16 | A-1 (11) | Pre-2 (73) | PTG2.5 (8) | MOCA (8) | E1 (0.8) | 0.85 | 28 | 31 | 48 | 1 | 3.2 | 1 | 1 |
| Example 17 | A-1 (12) | Pre-2 (73) | PTG2.5 (6) | MOCA (9) | E1 (0.8) | 0.85 | 36 | 39 | 60 | 1 | 2.8 | 1 | 1 |
| Example 18 | A-1 (16) | Pre-2 (71) | PTG2.5 (2) | MOCA (11) | E1 (0.8) | 0.85 | 46 | 49 | 74 | 1 | 2.4 | 2 | 1 |
| Example 19 | A-1 (12) | Pre-2 (66) | PTG6.5 (18) | MOCA (6) | E1 (0.8) | 0.85 | 21 | 18 | 37 | 1 | 3.5 | 1 | 2 |
| Example 20 | A-1 (15) | Pre-2 (67) | PTG6.5 (11) | MOCA (7) | E1 (0.8) | 0.85 | 28 | 31 | 46 | 1 | 3.4 | 1 | 1 |
| Example 21 | A-1 (17) | Pre-2 (68) | PTG6.5 (7) | MOCA (8) | E1 (0.8) | 0.85 | 32 | 38 | 53 | 1 | 2.7 | 1 | 1 |
| Example 22 | A-1 (10) | Pre-2 (65) | PTG6.5 (18) | MOCA (7) | E1 (0.8) | 0.85 | 23 | 33 | 38 | 1 | 2.9 | 1 | 1 |
| Example 23 | A-1 (12) | Pre-2 (67) | PTG6.5 (12) | MOCA (9) | E1 (0.8) | 0.85 | 34 | 35 | 58 | 1 | 3.3 | 1 | 1 |
| Example 24 | A-1 (15) | Pre-2 (69) | PTG6.5 (5) | MOCA (11) | E1 (0.8) | 0.85 | 45 | 49 | 73 | 1 | 2.6 | 1 | 1 |
| Example 25 | A-1 (12) | Pre-2 (60) | PTG10 (22) | MOCA (6) | E1 (0.8) | 0.85 | 23 | 20 | 39 | 1 | 3.2 | 1 | 1 |
| Example 26 | A-1 (14) | Pre-2 (62) | PTG10 (17) | MOCA (7) | E1 (0.8) | 0.85 | 25 | 25 | 47 | 1 | 3 | 1 | 1 |
| Example 27 | A-1 (15) | Pre-2 (64) | PTG10 (14) | MOCA (7) | E1 (0.8) | 0.85 | 30 | 34 | 51 | 1 | 3 | 1 | 1 |
| Example 28 | A-1 (15) | Pre-2 (64) | PEG10 (14) | MOCA (7) | E1 (0.8) | 0.85 | 24 | 36 | 33 | 1 | 3.1 | 1 | 2 |
| Example 29 | A-1 (18) | Pre-2 (67) | PEG10 (6) | MOCA (9) | E1 (0.8) | 0.85 | 33 | 47 | 60 | 1 | 2.8 | 1 | 2 |
| Example 30 | A-1 (15) | Pre-2 (64) | PPG10 (14) | MOCA (7) | E1 (0.8) | 0.85 | 27 | 40 | 39 | 1 | 3 | 1 | 2 |
| Example 31 | A-1 (18) | Pre-2 (67) | PPG10 (6) | MOCA (9) | E1 (0.8) | 0.85 | 34 | 48 | 63 | 1 | 2.6 | 1 | 2 |
| Example 32 | A-1 (12) | Pre-2 (67) | P530 (15) | MOCA (6) | E1 (0.8) | 0.85 | 23 | 42 | 51 | 1 | 2.9 | 1 | 1 |
| Example 33 | A-1 (15) | Pre-2 (67) | P530 (9) | MOCA (7) | E1 (0.8) | 0.85 | 31 | 49 | 61 | 1 | 2.8 | 1 | 1 |
| Example 34 | A-1 (5) | Pre-2 (85) | DEG (8) | MOCA (2) | E1 (0.8) | 0.85 | 24 | 49 | 53 | 1 | 2.4 | 1 | 2 |
| Example 35 | A-1 (11) | Pre-2 (77) | MPD (4) | MOCA (8) | E1 (0.8) | 0.85 | 40 | 45 | 65 | 1 | 2.3 | 2 | 1 |
| Example 36 | A-1 (13) | Pre-2 (75) | C1 (2) | MOCA (9) | E1 (0.8) | 0.85 | 45 | 48 | 75 | 2 | 2.3 | 2 | 1 |
| Example 37 | A-1 (11) | Pre-2 (75) | C2 (6) | MOCA (8) | E1 (0.8) | 0.85 | 36 | 46 | 59 | 1 | 2.6 | 1 | 1 |
| Example 38 | A-1 (13) | Pre-2 (73) | C2 (3) | MOCA (9) | E1 (0.8) | 0.85 | 44 | 49 | 68 | 2 | 2.5 | 2 | 1 |
| Example 39 | A-1 (16) | Pre-2 (72) | C2 (1) | MOCA (11) | E1 (0.8) | 0.85 | 50 | 50 | 79 | 2 | 2.2 | 2 | 1 |
| Example 40 | A-1 (11) | Pre-2 (76) | C3 (5) | MOCA (8) | E1 (0.8) | 0.85 | 47 | 50 | 76 | 1 | 2.3 | 2 | 1 |
| Example 41 | A-1 (11) | Pre-2 (75) | C4 (6) | MOCA (8) | E1 (0.8) | 0.85 | 50 | 50 | 81 | 1 | 2.2 | 2 | 1 |
| Example 42 | A-1 (15) | Pre-2 (69) | C5 (5) | MOCA (11) | E1 (0.8) | 0.85 | 55 | 50 | 86 | 2 | 2.2 | 2 | 1 |
| Comparative Example 1 | A-1 (21) | Pre-2 (70) | - | MOCA (9) | E1 (0.8) | 0.85 | 44 | 51 | 69 | 2 | 2.1 | 2 | 1 |
| Comparative Example 2 | - | Pre-2 (78) | - | MOCA (22) | E1 (0.8) | 0.85 | 66 | 61 | 91 | 1 | 1.9 | 3 | 2 |
| Comparative Example 3 | A-1 (17) | Pre-2 (71) | - | MOCA (12) | E1 (0.8) | 0.8 | 54 | 54 | 86 | 2 | 2 | 2 | 1 |
| Comparative Example 4 | A-2 (37) | Pre-2 (55) | - | MOCA (8) | E1 (0.8) | 0.85 | 40 | 38 | 60 | 4 | 2.4 | 1 | 5 |

The polishing pads including the cured products of the curable compositions of Examples which satisfied the requirements of the present invention were superior in the abrasion resistance and polishing rate, and were also superior in the mechanical properties. The curable compositions of Examples also had good handleability.

On the other hand, the polishing pads obtained from the curable compositions of Comparative Examples 1 to 3 which did not satisfy the requirements of the present invention were poorer in the abrasion resistance and polishing rate as compared with those of Examples. The curable composition of Comparative Example 4 had poor handleability.

## Claims

1. A curable composition comprising
(A) a cyclic molecule that contains three or more side chains each having at a terminal thereof an active hydrogen-containing group,
(B) a urethane prepolymer having an iso(thio)cyanate group on each of both terminals of a molecule,
(C) a diol, and
(D) an amino group-containing monomer.

2. The curable composition according to claim 1, wherein in (A) the cyclic molecule which contains three or more side chains each having at a terminal thereof an active hydrogen-containing group, the side chains each having at a terminal thereof an active hydrogen-containing group have a molecular weight of 300 or more in terms of number average molecular weight.

3. The curable composition according to claim 1 or 2, wherein in (A) the cyclic molecule which contains three or more side chains each having at a terminal thereof an active hydrogen-containing group, the cyclic molecule comprises a cyclodextrin.

4. The curable composition according to any one of claims 1 to 3, wherein in (A) the cyclic molecule that contains three or more side chains each having at a terminal thereof an active hydrogen-containing group, the active hydrogen-containing group comprises a hydroxy group.

5. The curable composition according to any one of claims 1 to 4, wherein (C) the diol has a number average molecular weight of 100 to 2,000.

6. The curable composition according to any one of claims 1 to 5, wherein (B) the urethane prepolymer which has an iso(thio)cyanate group on each of both terminals of a molecule has an iso(thio)cyanate equivalent of 300 to 1,000.

7. The curable composition according to any one of claims 1 to 6, wherein (C) the diol is contained in an amount of 2 to 50 parts by mass based on 100 parts by mass of a total of the component (A), the component (B), the component (C), and the component (D).

8. The curable composition according to any one of claims 1 to 7, further comprising (E) a fine hollow particle.

9. The curable composition according to claim 8, wherein (E) the fine hollow particle is a fine hollow particle comprising a urethane resin or a melamine resin.

10. A cured product obtained by curing the curable composition according to any one of claims 1 to 9.

11. A polishing pad comprising the cured product according to claim 10.
